# EUROPEAN PATENT APPLICATION

(11) **EP 3 561 521 A1**
(43) Date of publication of application: **30.10.2019**
(21) Application number: 19171342.9
(22) Date of filing: 26.04.2019
(51) Int. Cl.: G01P 21/02, G01R 31/00, G01P 15/16, G01P 5/165

(54) **REAL TIME IN FIELD MONITORING OF AIR DATA PITOT TUBE HEATING ARRANGEMENT**

(30) Priority: 26.04.2018 IN 201811015860
(71) Applicant: ROSEMOUNT AEROSPACE INC., Burnsville, MN 55306-4898 (US)
(72) Inventor: JHA, Ashutosh Kumar, 560067 Karnataka (IN); NELSON, Jordan William, SAVAGE, MN Minnesota 55378 (US)
(74) Representative: Dehns

(57) **Abstract**

A monitoring device (320) is provided herein. The monitoring device (320) is in communication with one or more air data systems (110, 112). The monitoring device (320) includes a processor (321) and a memory (322) storing program instructions thereon. The program instructions executable by the processor (321) to implement a model (330). The model (330) includes a monitoring and comparing layer (340) utilizing parameters from the one or more air data systems (110, 112) to measure a performance and determine a drift. The model (330) includes an estimating layer (360) providing a degradation model determining a degradation of health parameters of the one or more air data systems (110, 112). The model (330) includes a predicting layer (370) monitoring changes and patterns in the drift and the degradation of health parameters.

## Description

### CROSS REFERENCE TO RELATED APPLICATIONS

This application is a Non-Provisional Application of Indian Application No. 201811015860 filed April 26, 2018, which is incorporated herein by reference in its entirety herein.

### BACKGROUND

Exemplary embodiments pertain to the art of real time in field monitoring of air data Pitot tube heater element.

In general, an air data system is one of the most critical systems on board an aircraft, as it provides critical information to the aircraft and pilot throughout the flight regime. Further, the air data system is used for measuring total pressure, impact pressure, angle of attack, static pressure, and angle of sideslip parameters, along with calculating airspeed, altitude, attitude, Mach number, angle of attach, angle of Sideslip etc.

Air data Pitot tubes are fitted on the nose of aircraft outside the skin and are exposed to harsh weather conditions and extreme cool temperatures, which can result in icing of the air data Pitot tubes. Conventional de-icing systems prevent icing by heating the air data Pitot tubes from the inside. Heater elements of the air data Pitot tubes degrade over time and fail abruptly on the field leading to icing condition of the air data Pitot tubes and blockage of pressure ports.

### BRIEF DESCRIPTION

In accordance with one or more embodiments, a monitoring device is provided herein. The monitoring device is in communication with one or more air data systems. The monitoring device includes a processor and a memory storing program instructions thereon. The program instructions are executable by the processor to implement a model. The model includes a monitoring and comparing layer utilizing parameters from the one or more air data systems to measure a performance and determine a drift. The model includes an estimating layer providing a degradation model determining a degradation of health parameters of the one or more air data systems. The model includes a predicting layer monitoring changes and patterns in the drift and the degradation of health parameters.

In accordance with one or more embodiments or the monitoring device embodiment above, the one or more air data systems can comprise an air data Pitot tube heater element, and the air data Pitot tube heater element can be monitored by the monitoring device.

In accordance with one or more embodiments or any or the monitoring device embodiments above, the parameters can comprise current, voltage, outside ambient temperature, value of free stream of air, and duty cycle of the air data Pitot tube heater element.

In accordance with one or more embodiments or any or the monitoring device embodiments above, the predicting layer can predict when heater elements of the one or more air data systems are out of a functioning threshold.

In accordance with one or more embodiments or any or the monitoring device embodiments above, the monitoring device can generate reports comprising faults, failures, performance, degradation, prognostics, or diagnostics based on operations of the monitoring and comparing layer, the estimating layer, and the predicting layer.

In accordance with one or more embodiments or any or the monitoring device embodiments above, the monitoring device can receive data transmissions including the parameters from a sub-system connected the one or more air data systems.

In accordance with one or more embodiments or any or the monitoring device embodiments above, the monitoring device can compare the performance parameters with an output of a software model generated using physics or mathematical based modelling of the one or more air data systems.

In accordance with one or more embodiments, a system is provided. The system includes a sub-system connected the one or more air data systems. The sub-system includes an interface communicating to at least one monitoring device. The system includes the at least one monitoring device in communication with the one or more air data systems via the sub-system. The monitoring device includes a processor and a memory storing program instructions thereon. The program instructions are executable by the processor to implement a model. The model includes a monitoring and comparing layer utilizing parameters from the one or more air data systems to measure a performance and determine a drift. The model includes an estimating layer providing a degradation model determining a degradation of health parameters of the one or more air data systems. The model includes a predicting layer monitoring changes and patterns in the drift and the degradation of health parameters.

In accordance with one or more embodiments or the system embodiment above, the one or more air data systems can comprise an air data Pitot tube heater element, and the air data Pitot tube heater element can be monitored by the monitoring device.

In accordance with one or more embodiments or any or the system embodiments above, the parameters can comprise current, voltage, outside ambient temperature, value of free stream of air, and duty cycle of the air data Pitot tube heater element.

In accordance with one or more embodiments or any or the system embodiments above, the predicting layer can predict when heater elements of the one or more air data systems are out of a functioning threshold.

In accordance with one or more embodiments or any or the system embodiments above, the monitoring device can generate reports comprising faults, failures, performance, degradation, prognostics, or diagnostics based on operations of the monitoring and comparing layer, the estimating layer, and the predicting layer.

In accordance with one or more embodiments or any or the system embodiments above, the monitoring device can receive data transmissions including the parameters from a sub-system connected the one or more air data systems.

In accordance with one or more embodiments or any or the system embodiments above, the monitoring device can compare the performance parameters with an output of a software model generated using physics or mathematical based modelling of the one or more air data systems.

In accordance with one or more embodiments a processor-implemented method for heater performance monitoring, evaluation, and analysis is provided. The processor-implemented method is implemented via program instructions stored on a memory of a monitoring device in communication with one or more air data systems. The program instructions are executable by a processor of the monitoring device to implement a model. The method processor-implemented includes utilizing parameters, by a monitoring and comparing layer of the model, from the one or more air data systems to measure a performance and determine a drift. The method processor-implemented includes providing, by an estimating of the model, a degradation model determining a degradation of health parameters of the one or more air data systems. The method processor-implemented includes monitoring, by a predicting layer of the model, changes and patterns in the drift and the degradation of health parameters.

In accordance with one or more embodiments or the processor-implemented method embodiment above, the one or more air data systems can comprise an air data Pitot tube heater element, and the air data Pitot tube heater element can be monitored by the monitoring device.

In accordance with one or more embodiments or any or the processor-implemented method embodiments above, the parameters can comprise current, voltage, outside ambient temperature, value of free stream of air, and duty cycle of the air data Pitot tube heater element.

In accordance with one or more embodiments or any or the processor-implemented method embodiments above, the predicting layer can predict when heater elements of the one or more air data systems are out of a functioning threshold.

In accordance with one or more embodiments or any or the processor-implemented method embodiments above, the monitoring device can generate reports comprising faults, failures, performance, degradation, prognostics, or diagnostics based on operations of the monitoring and comparing layer, the estimating layer, and the predicting layer.

In accordance with one or more embodiments or any or the processor-implemented method embodiments above, the monitoring device can receive data transmissions including the parameters from a sub-system connected the one or more air data systems.

In accordance with one or more embodiments or any or the processor-implemented method embodiments above, the monitoring device can compare the performance parameters with an output of a software model generated using physics or mathematical based modelling of the one or more air data systems.

### BRIEF DESCRIPTION OF THE DRAWINGS

The following descriptions should not be considered limiting in any way. With reference to the accompanying drawings, like elements are numbered alike:
FIG. 1 depicts a system in accordance with one or more embodiments;
FIG. 2 depicts a process flow of a system in accordance with one or more embodiments;
FIG. 3 depicts a monitoring system in accordance with one or more embodiments; and
FIG. 4 depicts a process flow of a model in accordance with one or more embodiments.

### DETAILED DESCRIPTION

In accordance with one or more embodiments, a degradation in a functioning air data Pitot tube heater element is monitored to analyze a degradation trend and to predict a remaining useful life for the air data Pitot tube heater element. The technical effects and benefits of the one or more embodiments includes an optimized implementation of condition based monitoring, prognostics, and diagnostics that improves an air data system's availability and safety by improving the performance of the air data system and reducing its field failure rate.

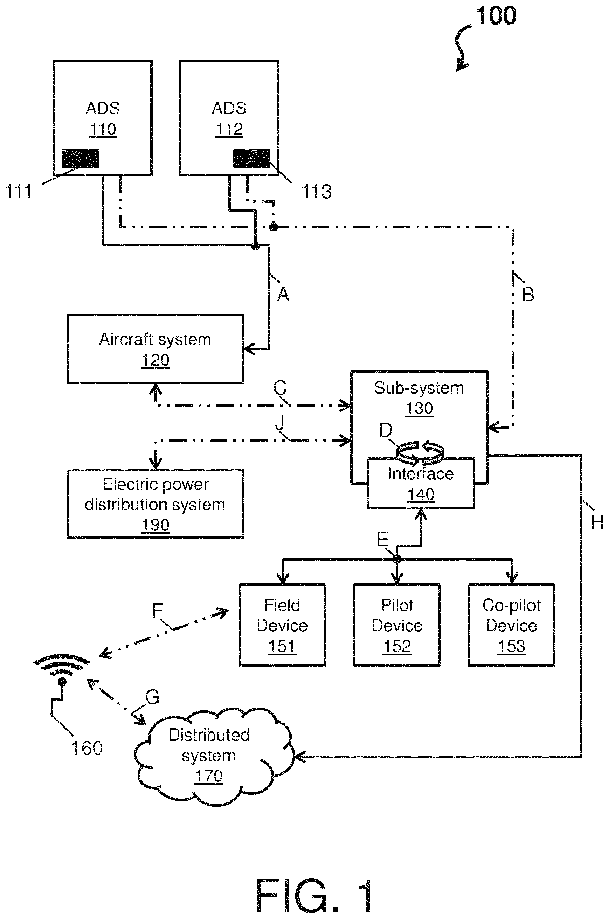

FIG. 1 depicts a system 100 in accordance with one or more embodiments. The system 100 comprise a first conventional air data system 110, an air data Pitot tube heater element 111, a second conventional air data system 112, an air data Pitot tube heater element 113, an aircraft system 120, a sub-system 130, an interface 140, a field device 151, a pilot device 152, a co-pilot device 153, an airport infrastructure 160, a distributed system 170, and an electric power distribution system 190.

The system 100 is a high level air data heater performance monitoring architecture for performance and fault monitoring the first conventional air data system 110 and the second conventional air data system 112 (or any other system) comprising air data Pitot tube heater elements 111, 113 in field through use of the sub-system 130 and the interface 140.

In general, air data systems (e.g., the first conventional air data system 110 and the second conventional air data system 112) are exposed to extreme temperature and suffer from icing due to abrupt failure of air data Pitot tube heater 111, 113 elements 111, 113 therein, when an aircraft is in service. Abrupt failure of the air data Pitot tube heater elements can result in degradation of fight performance, down time, and added cost of in field maintenance.

A conventional attempt to address the abrupt failure of the air data Pitot tube heater elements 111, 113 includes adding a thermocouple on a surface of a Pitot tube to measure temperature using a digital device against an operating range. Yet, not only it is difficult to satisfy an objective of revalidating heater performance on return to service, any malfunctioning of the air data Pitot tube heater elements 111, 113 is alerted only when it fails. Further, counts by a monitoring circuit of the digital device for the air data Pitot tube heater elements 111, 113 and faults and failures are stored in non-volatile memory of the digital device for a limited cycles, which are downloaded when aircraft lands through a physical connection through serial or controller access network (CAN) bus or Aeronautical Radio, Incorporated (ARINC) communication between the digital device and a field computer using special equipment. The challenges with this conventional attempt include an inability to provide real time monitoring of the air data Pitot tube heater elements 111, 113, difficultly in and additional setup for revalidation of heater performance on a return service of the air data Pitot tube heater elements 111, 113, a lack of a continuous process, degradation in performance where the air data Pitot tube heater elements 111, 113 are heating less or heating excessively (note this presently cannot be monitored unless it fails and stops withdrawing current), reactive manual actions to address failures (only when air data system heater malfunctions), constraints due to the non-volatile memory of the digital device for fault storage and data, and inability to learn from historic data cannot be performed due to lack of data.

In contrast to the conventional attempt to address the abrupt failure of the air data Pitot tube heater elements 111, 113, the system 100 provides a continuous monitoring of health and performance of the air data Pitot tube heater elements 111, 113, along with revalidation of the health and performance on return to service and estimation of a remaining life of the air data Pitot tube heater elements 111, 113 to prevent sudden field failures. For instance, the continuous monitoring by the system 100 includes providing a heater health status using a sub-system 130 (e.g., an aircraft interface device) and the interface 140 (e.g., a tablet interface module).

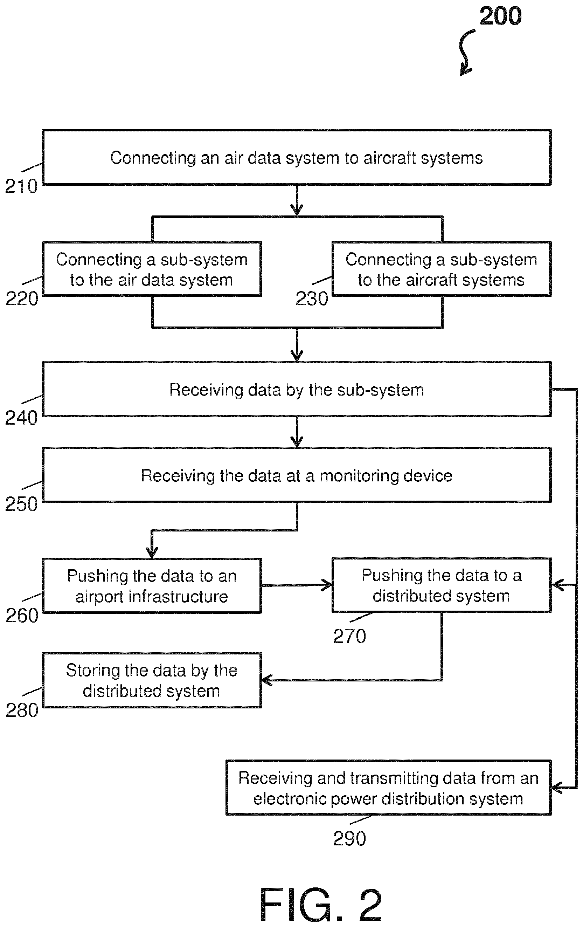

In contrast to the conventional attempt to address the abrupt failure of the air data Pitot tube heater elements 111, 113, the system 100 provides monitoring, prognostics, and diagnostics of critical parameters of the air data Pitot tube heater elements 111, 113, when an aircraft including the system 100 is in flight and on ground. The system 100 also provides acquiring and processing of critical health parameters of the first conventional air data system 110 and the second conventional air data system 112 and provides a configuration for elements of the system 100 in flight and on ground. The system 100 leverages the distributed system 170 for data storage, which further provides stored further refinement with respect to an accuracy of any estimations and/or predictions by the system 100. The system 100 can utilize a resistance of the air data Pitot tube heater elements 111, 113 at a controlled temperature, density of heat at various points within an assembly of the air data Pitot tube heater elements 111, 113, any insulation resistance, etc. to calibrate and improve these estimations and/or predictions to eliminate biases introduce by variability during manufacturing. As shown in FIG. 1, demarcations A, B, C, D, E, F, G, H, and J identify communication operations as further described with respect to FIG. 2.

Turning now to FIG. 2, a process flow 200 of the system 100 is depicted in accordance with one or more embodiments. The process flow 200 begins at block 210, where the conventional air data systems 110, 112 are connected to the aircraft system 120, which includes aircraft avionics, flight control, navigation, displays, etc. (e.g., see Demarcation A of FIG. 1). The conventional air data systems 110, 112 can comprise a smart probe or traditional air data Pitot including any Pitot tube based system (e.g., the air data Pitot tube heater elements 111, 113). The conventional air data systems 110, 112 can be connected to the aircraft system 120 using a communication protocols, such as Aeronautical Radio INC. 429, RS 232/422, Ethernet, and CAN, based on aircrafts configuration.

At block 220, the sub-system 130 connects to the conventional air data systems 110, 112 (e.g., see Demarcation B of FIG. 1). In this regard, the sub-system 130 is connected to a system to be monitored (e.g., the air data Pitot tube heater elements 111, 113, ice detectors, windshields, rotors, engines, etc.). The sub-system 130 can be connected to the conventional air data systems 110, 112 using a communication protocols, such as Aeronautical Radio INC. 429, serial communication, and CAN.

At block 230, the sub-system 130 connects to the aircraft system 120 (e.g., see Demarcation C of FIG. 1). The sub-system 130 can be connected to the aircraft system 120 using a communication protocols, such as Aeronautical Radio INC. 429, serial communication, and CAN. This connection can be in conjunction with or in alternate to the connection shown by Demarcation B.

At block 240, the sub-system 130 receives data from the conventional air data systems 110, 112 and/or the air data Pitot tube heater elements 111, 113 (e.g., see Demarcation D of FIG. 1). At block 250, monitoring devices (e.g., the field device 151, the pilot device 152, and the co-pilot device 153) receive the data (e.g., see Demarcation E of FIG. 1). For example, the sub-system 130 can push the data received from system under health monitoring through the interface 140 (e.g., over Ethernet, universal serial bus, or Bluetooth) to one or more of the field device 151, the pilot device 152, and the co-pilot device 153 for performance of monitoring and other calculations.

At block 260, the one or more of the field device 151, the pilot device 152, and the co-pilot device 153 push the data to the airport infrastructure 160 (e.g., see Demarcation F of FIG. 1). The data can be pushed wirelessly. At block 270, the airport infrastructure 160 pushes the data to the distributed system 170 (e.g., see Demarcation G of FIG. 1). For example, the airport infrastructure 160 provides access to the distributed system 170 for storage of data and on ground processing of data. The data can be pushed wirelessly. At block 280, the distributed system 170 stores the data.

Returning to block 240, after the sub-system 130 receives data from the conventional air data systems 110, 112 and/or the air data Pitot tube heater elements 111, 113, the process flow 200 can proceed directly to block 270 (e.g., the data coming from the air data Pitot tube heater elements 111, 113 to the sub-system 130 can also be pushed directly to the distributed system 170 using, for example, a satellite communication, for storage and/or on ground processing, see Demarcation H of FIG. 1) or to block 290.

At block 290, the sub-system 130 receives and transmitting data from the electric power distribution system 190 (e.g., see Demarcation J of FIG. 1). For example, the electric power distribution system 190 onboard the aircraft also monitors power supply voltage and current supplied to the air data Pitot tube heater elements 111, 113 and provides corresponding data to the sub-system 130. The sub-system 130, in turn, forwards the data is forwarded to the one or more of the field device 151, the pilot device 152, and the co-pilot device 153 and/or the distributed system 170 for storage and computation of health status and remaining useful life of heater element.

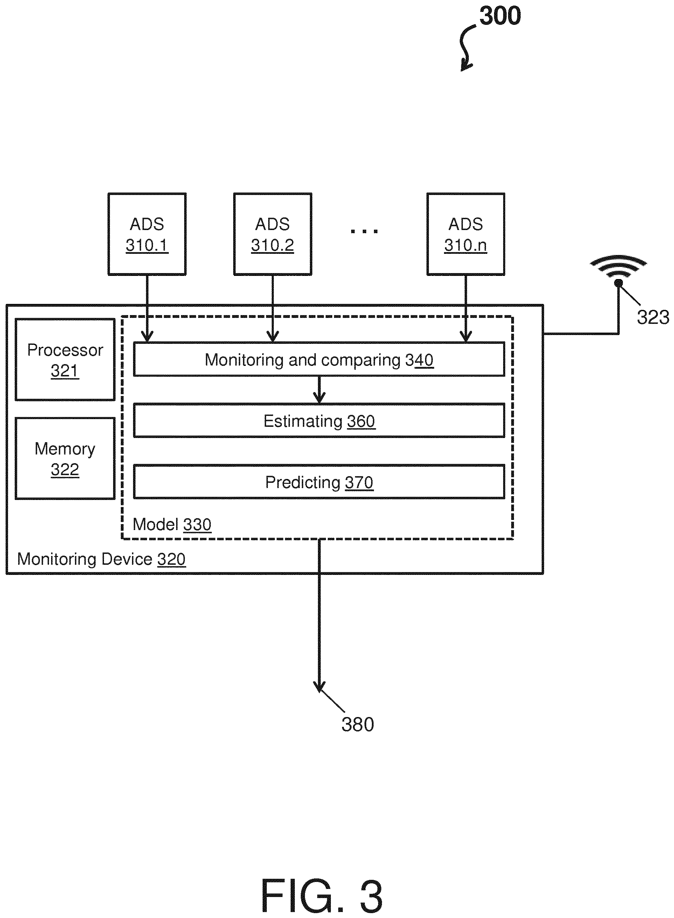

FIG. 3 depicts a monitoring system 300 in accordance with one or more embodiments. The monitoring system 300 comprises one or more air data systems (ADS 310.1, ADS 310.2 ... ADS 310.n, where n is an integer greater than 0) in communication with a monitoring device 320.

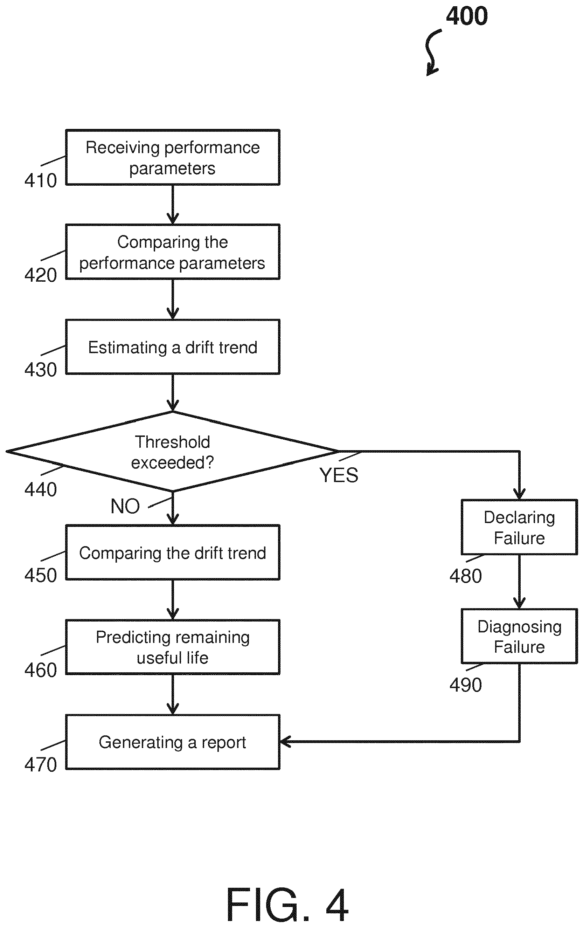

The monitoring device 320 can be any computing device comprising one or more central processing units (e.g., a processor 321). The processor 321, also referred to as a processing circuit, is coupled via a system bus to a system memory (e.g., a memory 322) and various other components. Software for execution on the monitoring device 320 may be stored in the system memory 322. The memory 322 can include a read only memory (ROM) and a random access memory (RAM). The ROM is coupled to the system bus and may include a basic input/output system (BIOS), which controls certain basic functions of the monitoring device 320. The RAM is read-write memory coupled to the system bus for use by the processor 321. The memory 322 is an example of a tangible storage medium readable by the processor 321, where the software is stored as instructions for execution by the processor 321 to cause the monitoring device 320 to operate, such as is described herein with reference to blocks 330, 340, 360, and 370 and/or FIGS. 1 and 4. Examples of computer program product and the execution of such instruction is discussed herein in more detail. The monitoring device 320 can communicate with any external system through a wired and/or wireless connection 323.

In accordance with one or more embodiments, the monitoring device 320 can be a tablet computer used for data gathering and in field processing of the data, providing reports related to performance monitoring, prognostics, and diagnostics, and for determining remaining useful life of a system to be monitored (e.g., the air data Pitot tube heater elements 111, 113). In operation and as shown in FIG. 3, the software of the monitoring device 320 executes a model 330 to perform monitoring and comparing (340), estimating (360), and predicting (370).

The monitoring and comparing layer 340 of the model 330 can comprise an application, software layer, algorithm, and/or a sub-model for evaluating the performance of the heater. The monitoring and comparing layer 340 utilizes critical parameters to measure the performance of the system to be monitored, like current, voltage, outside ambient temperature, value of free stream of air, duty cycle of heater, etc. The critical parameters are measured and compared against a model of the system to be monitored, the model being generated from an empirical study and/or modelling (like physics based, mathematical model, etc.), to provide revalidating of the performance of system to be monitored on return to service. The monitoring and comparing layer 340 also compares a performance cross side and on side of the ADS 310.1, the ADS 310.2 ... the ADS 310.n and provides the status. Any drift in the critical parameters are measured in the monitoring and comparing layer 340 and provided for other layers of the model for prognostics and diagnostics.

The estimating layer 360 of the model 330 can comprise an application, software layer, algorithm, and/or degradation model built on basis of learning systems and other empirical data of the ADS 310.1, the ADS 310.2 ... the ADS 310.n. The degradation model generated by subjecting the ADS 310.1, the ADS 310.2 ... the ADS 310.n to different tests, practical conditions, and monitoring the degradation of key health parameters until the failure of the ADS 310.1, the ADS 310.2 ... the ADS 310.n.

The predicting layer 370 of the model 330 can comprise an application, software layer, algorithm, and/or sub-model and can monitor the change in drift patterns and predicts when heater elements of the ADS 310.1, the ADS 310.2 ... the ADS 310.n are out of a nominal functioning threshold.

Based on the operations of the monitoring and comparing layer 340, the estimating layer 360, and the predicting layer 370, the model 330 can generate reports 380. The reports 380 can comprise faults, failures, performance, degradation, prognostics, diagnostics, etc. in interpretable format to pilot, co-pilot, maintenance technician, field engineers, etc.

FIG. 4 depicts a process flow 400 of a model 330 in accordance with one or more embodiments. The process flow 400 comprises a heater performance monitoring, a performance evaluation, a degradation analysis and determination of remaining useful life for any air data system (ADS 310.1, ADS 310.2 ... ADS 310.n).

The process flow 400 begin at block 410, the monitoring device 320 receives performance parameters. That is, the monitoring device 320 monitors critical parameters for a defined environmental conditions. The monitoring device 320 gets the environmental condition from the ADS 310.1, the ADS 310.2 ... the ADS 310.n.

At block 420, the monitoring device 320 compares the performance parameters. The monitoring device 320 gathers this information and compares it with a software model output, which is generated for similar environmental condition. The software model can be generated using physics based modelling and/or mathematical modelling (and the like) of air data system heater parameters.

At block 430, the monitoring device 320 estimates a drift trend. The monitoring device 320 determines the drift in the monitored performance parameters and saves the drift for trend generation. Not that, if any computation becomes extensive or it requires big data processing, the monitoring device 320 sends the drift to cloud (the distributed system 170) and uses services therein for computation of a remaining useful life.

At decision block 440, the monitoring device 320 determines whether a threshold is exceed. If the threshold is not exceed or the drift trend is within threshold, the process flow 200 process to blocks 450, 460, and 470 (as indicated by the NO arrow). At block 450, the monitoring device 320 compares the drift trend. At block 490, the monitoring device 320 predicts remaining useful life. At block 470, the monitoring device 320 generates a report.

For example, if the drift is within threshold, then the monitoring device 320 determines the degradation and the probes heater element's remaining useful life. Software of the monitoring device 320 further compares the drift trend with the trend generated from test models and other models coming from empirical data. The data generated from learning model is used to generate the degradation model of air data system heater element parameters, which are used herein for comparison. As time progresses and more and more data becomes available, learning model data is tweaked to match actual failures and for trend setting. The drift in the parameter of air data system heater element is extrapolated to match the trend of degradation model until probe heater element has failed to match the time line and used for calculating the remaining useful life of the air data system heater element under consideration as per comparison. Detailed reports are generated for prognostics, diagnostics, remaining useful life, performance degradation etc. Diagnostics CAN highlight the failures and faults report

If the threshold is exceed, the process flow 200 process to blocks 480 and 490 (as indicated by the YES arrow). At block 480, the monitoring device 320 declares a failure. At block 490, the monitoring device 320 diagnosis a failure. That is, if the drift goes out of threshold, the monitoring device 320 declares the air data system heater element under consideration as failure and generates the diagnostics report.

Embodiments herein comprise the technical effects and benefits of an air data system being connected to a sub-system and its parameters are collected at a monitoring device using the sub-system and an interface for real time monitoring of air data system heater element (or health of other subsystems of air data system). The technical effects and benefits include an air data system heater element parameters being compared against physics, mathematical, empirical data, etc. based models for calculation of drift in a sensed value and hence for evaluating the performance degradation of air data system heater element in real time and/or on field.

Further, the technical effects and benefits include a comparison of drift of parameters against model for detecting the failure and generation of diagnostics report based on failure using a monitoring device. The technical effects and benefits include generating the degradation model using the results of learning over period of time and from big data and using it for estimating the remaining useful life of air data system heater element. The technical effects and benefits include determining the remaining useful life by comparing the trend of air data system heater element drift against the drift coming from a model generated out of learning system and extrapolated over time. For example, the extrapolation can be executed by matching the trend given the timeline when drift will go out of threshold and fail. The technical effects and benefits include development a distributed system, storage of air data system parameters on the distributed system, and access of the distributed system by the monitoring device to generate trends required for prognostics and diagnostics of heater element. The technical effects and benefits include revalidation of heater performance on return to service.

Furthermore, the technical effects and benefits include a prediction of failure and a determination of remaining useful life of heater element to prevent sudden field failures of air data heater and associated cost of delay of flight. The technical effects and benefits include real time performance monitoring of air data system heater element and detection of degradation in its performance to mitigate any problems, which result in better efficiency of air data heater. The technical effects and benefits include a reduction in maintenance cost and faster turnaround time for maintenance associated to heater failure of air data system. The technical effects and benefits include better and more efficient in field maintenance for any air data system heater. The technical effects and benefits include in field monitoring of faults and failures to provide diagnostics capabilities for air data heater. The technical effects and benefits include trend generation and learning from historic data of air data system heater to improve learning and optimize models for better prediction of remaining useful life of air data system heater.

A detailed description of one or more embodiments of the disclosed apparatus and method are presented herein by way of exemplification and not limitation with reference to the Figures.

Embodiments herein may be a system, a method, and/or a computer program product at any possible technical detail level of integration. The computer program product may include a computer readable storage medium (or media) having computer readable program instructions thereon for causing a processor to carry out aspects of the embodiments herein.

The computer readable storage medium can be a tangible device that can retain and store instructions for use by an instruction execution device. The computer readable storage medium may be, for example, but is not limited to, an electronic storage device, a magnetic storage device, an optical storage device, an electromagnetic storage device, a semiconductor storage device, or any suitable combination of the foregoing. A non-exhaustive list of more specific examples of the computer readable storage medium includes the following: a portable computer diskette, a hard disk, a random access memory (RAM), a read-only memory (ROM), an erasable programmable read-only memory (EPROM or Flash memory), a static random access memory (SRAM), a portable compact disc read-only memory (CD-ROM), a digital versatile disk (DVD), a memory stick, a floppy disk, a mechanically encoded device such as punch-cards or raised structures in a groove having instructions recorded thereon, and any suitable combination of the foregoing. A computer readable storage medium, as used herein, is not to be construed as being transitory signals per se, such as radio waves or other freely propagating electromagnetic waves, electromagnetic waves propagating through a waveguide or other transmission media (e.g., light pulses passing through a fiber-optic cable), or electrical signals transmitted through a wire.

Computer readable program instructions described herein can be downloaded to respective computing/processing devices from a computer readable storage medium or to an external computer or external storage device via a network, for example, the Internet, a local area network, a wide area network and/or a wireless network. The network may comprise copper transmission cables, optical transmission fibers, wireless transmission, routers, firewalls, switches, gateway computers and/or edge servers. A network adapter card or network interface in each computing/processing device receives computer readable program instructions from the network and forwards the computer readable program instructions for storage in a computer readable storage medium within the respective computing/processing device.

Computer readable program instructions for carrying out operations of the embodiments herein may be assembler instructions, instruction-set-architecture (ISA) instructions, machine instructions, machine dependent instructions, microcode, firmware instructions, state-setting data, configuration data for integrated circuitry, or either source code or object code written in any combination of one or more programming languages, including an object oriented programming language such as Smalltalk, C++, or the like, and procedural programming languages, such as the "C" programming language or similar programming languages. The computer readable program instructions may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider). In some embodiments, electronic circuitry including, for example, programmable logic circuitry, field-programmable gate arrays (FPGA), or programmable logic arrays (PLA) may execute the computer readable program instructions by utilizing state information of the computer readable program instructions to personalize the electronic circuitry, in order to perform aspects of the embodiments herein.

Aspects of the embodiments herein are described herein with reference to flowchart illustrations and/or block diagrams of methods, apparatus (systems), and computer program products according to embodiments of the invention. It will be understood that each block of the flowchart illustrations and/or block diagrams, and combinations of blocks in the flowchart illustrations and/or block diagrams, can be implemented by computer readable program instructions.

These computer readable program instructions may be provided to a processor of a general purpose computer, special purpose computer, or other programmable data processing apparatus to produce a machine, such that the instructions, which execute via the processor of the computer or other programmable data processing apparatus, create means for implementing the functions/acts specified in the flowchart and/or block diagram block or blocks. These computer readable program instructions may also be stored in a computer readable storage medium that can direct a computer, a programmable data processing apparatus, and/or other devices to function in a particular manner, such that the computer readable storage medium having instructions stored therein comprises an article of manufacture including instructions which implement aspects of the function/act specified in the flowchart and/or block diagram block or blocks.

The computer readable program instructions may also be loaded onto a computer, other programmable data processing apparatus, or other device to cause a series of operational steps to be performed on the computer, other programmable apparatus or other device to produce a computer implemented process, such that the instructions which execute on the computer, other programmable apparatus, or other device implement the functions/acts specified in the flowchart and/or block diagram block or blocks.

The term "about" is intended to include the degree of error associated with measurement of the particular quantity based upon the equipment available at the time of filing the application.

The terminology used herein is for the purpose of describing particular embodiments only and is not intended to be limiting of the present disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the present disclosure has been described with reference to an exemplary embodiment or embodiments, it will be understood by those skilled in the art that various changes may be made and equivalents may be substituted for elements thereof without departing from the scope of the present disclosure. In addition, many modifications may be made to adapt a particular situation or material to the teachings of the present disclosure without departing from the essential scope thereof. Therefore, it is intended that the present disclosure not be limited to the particular embodiment disclosed as the best mode contemplated for carrying out this present disclosure, but that the present disclosure will include all embodiments falling within the scope of the claims.

## Claims

1. A monitoring device in communication with one or more air data systems, the monitoring device comprising a processor and a memory storing program instructions thereon, the program instructions executable by the processor to implement a model comprising:
a monitoring and comparing layer utilizing parameters from the one or more air data systems to measure a performance and determine a drift;
an estimating layer providing a degradation model determining a degradation of health parameters of the one or more air data systems; and
a predicting layer monitoring changes and patterns in the drift and the degradation of health parameters.

2. The monitoring device of claim 1, wherein the one or more air data systems comprises an air data Pitot tube heater element, and
wherein the air data Pitot tube heater element is being monitored by the monitoring device.

3. The monitoring device of claim 2, wherein the parameters comprise current, voltage, outside ambient temperature, value of free stream of air, and duty cycle of the air data Pitot tube heater element.

4. The monitoring device of claim 1, 2 or 3, wherein the predicting layer predicts when heater elements of the one or more air data systems are out of a functioning threshold.

5. The monitoring device of any preceding claim, wherein the monitoring device generates reports comprising faults, failures, performance, degradation, prognostics, or diagnostics based on operations of the monitoring and comparing layer, the estimating layer, and the predicting layer.

6. The monitoring device of any preceding claim, wherein the monitoring device receives data transmissions including the parameters from a sub-system connected the one or more air data systems.

7. The monitoring device of any preceding claim, wherein the monitoring device compares the performance parameters with an output of a software model generated using physics or mathematical based modelling of the one or more air data systems.

8. A system comprising
a sub-system connected the one or more air data systems, the sub-system comprising an interface communicating to at least one monitoring device; and
the at least one monitoring device in communication with the one or more air data systems via the sub-system, the monitoring device comprising a processor and a memory storing program instructions thereon, the program instructions executable by the processor to implement a model comprising:
a monitoring and comparing layer utilizing parameters from the one or more air data systems to measure a performance and determine a drift;
an estimating layer providing a degradation model determining a degradation of health parameters of the one or more air data systems; and
a predicting layer monitoring changes and patterns in the drift and the degradation of health parameters.

9. The system of claim 8, wherein the one or more air data systems comprises an air data Pitot tube heater element, and
wherein the air data Pitot tube heater element is being monitored by the monitoring device.

10. The system of claim 9, wherein the parameters comprise current, voltage, outside ambient temperature, value of free stream of air, and duty cycle of the air data Pitot tube heater element.

11. The system of claim 8, 9 or 10, wherein the predicting layer predicts when heater elements of the one or more air data systems are out of a functioning threshold.

12. The system of any of claims 8 to 11, wherein the monitoring device generates reports comprising faults, failures, performance, degradation, prognostics, or diagnostics based on operations of the monitoring and comparing layer, the estimating layer, and the predicting layer.

13. The system of any of claims 8 to 12, wherein the monitoring device receives data transmissions including the parameters from the sub-system connected the one or more air data systems.

14. The system of any of claims 8 to 13, wherein the monitoring device compares the performance parameters with an output of a software model generated using physics or mathematical based modelling of the one or more air data systems.
